Europäisches Patentamt

**European Patent Office**

**Office européen des brevets**

(11) Numéro de publication: **0 308 316**
**A1**

## DEMANDE DE BREVET EUROPEEN

(21) Numéro de dépôt: **88402300.3**

(22) Date de dépôt: **13.09.88**

(51) Int. Cl.⁴: **H 01 L 21/28**
H 01 L 21/82, H 01 L 21/76,
H 01 L 29/78

(30) Priorité: **18.09.87 FR 8712941**

(43) Date de publication de la demande:
**22.03.89  Bulletin  89/12**

(84) Etats contractants désignés: **DE ES GB IT NL**

(71) Demandeur: **SGS-THOMSON MICROELECTRONICS S.A.**
**7, Avenue Galliéni**
**F-94250 Gentilly  (FR)**

(72) Inventeur: **Bergemont, Albert**
**Cabinet Ballot-Schmit 84, Avenue Kléber**
**F-75116 Paris  (FR)**

(74) Mandataire: **Ballot, Paul Denis Jacques et al**
**Cabinet Ballot-Schmit 84, avenue Kléber**
**F-75116 Paris  (FR)**

(54) **Procédé d'auto-alignement des grilles flottantes de transistors à grille flottante d'une mémoire non volatile et mémoire obtenue selon ce procédé.**

(57)  On procède à l'auto-alignement des grilles flottantes de transistors à grille flottante d'une mémoire non volatile en réalisant sur un substrat (1) de silicium une couche (2) d'oxyde de grille surmontée sucessivement d'une couche (3) de polysilicium ultérieurement légèrement oxydée (13), et surmontée elle-même d'une couche (4) de nitrure de silicium. On définit des îlots (5) de nitrure de silicium correspondant aux emplacements des grilles flottantes des transistors. Après la définition et une gravure par plasma réactive, on dépose une deuxième couche plus fine (14) de nitrure. Puis on enlève cette deuxième couche par attaque plasma plein champ. On montre qu'on laisse ainsi subister des espaceurs (17,18) qui protègent les flancs (15,16) des îlots. Puis on fait croître un oxyde d'isolement épais (6) entre les îlots. On montre qu'on aligne ainsi simplement les bords de largeur des canaux de conduction des transistors sur les extrémités en bec d'oiseau des régions en oxyde épais.

FIG_1-a    FIG_1-b

EP 0 308 316 A1

## Description

**PROCEDE D'AUTO-ALIGNEMENT DES GRILLES FLOTTANTES DE TRANSISTORS A GRILLE FLOTTANTE D'UNE MEMOIRE NON VOLATILE ET MEMOIRE OBTENUE SELON CE PROCEDE.**

La présente invention a pour objet un procédé d'auto-alignement des grilles flottantes de transistors à grille flottante d'une mémoire non volatile. Elle a aussi pour objet une mémoire obtenue par ce procédé. Elle trouve son application dans le domaine des mémoires dites EPROM ou EEPROM et plus particulièrement dans le domaine des cartes à mémoire où de telles mémoires sont utilisées. Elle est destinée à permettre une intégration de plus en plus grande de ces mémoires en vue d'augmenter la capacité de points mémoires qu'elles sont susceptibles de contenir.

Dans les mémoires non volatiles où l'organe de stockage des informations est un transistor à grille flottante, les principaux obstacles à l'augmentation de l'intégration se situent dans le caractère flottant de la grille flottante placée de façon intemédiaire entre le canal de conduction du transistor et une grille de commande de ce transistor, et dans la structure, dite en bec d'oiseau, des séparations et oxyde épais qui permettent de répartir les points mémoire dans la mémoire. De par leur existence les deux grilles superposées, flottante et de commande, nécessitent des opérations d'alignement supplémentaires dont le respect n'est assuré qu'en prenant des tolérances de réalisation importantes. Le choix de ces tolérances de réalisation s'exerce bien entendu au détriment de la capacité de la mémoire. Cette capacité est fixé par une règle de dessin qui tient compte d'une part des tolérances d'alignement des masques successifs utilisés dans la fabrication du circuit intégré et d'autre part d'une garde que l'on se donne, à la limite de la tolérance, et qui dépend des pertes de cotes dues à la gravure ou dues aux variations de réalisation liées aux variations mêmes des procédés de fabrication. Avec une tolérance d'alignement de l'ordre de 0,5 micromètres, et une garde de 0,6 micromètres, cette dernière due pour moitié à la perte de côte de gravure et pour moitié aux variations du procédé de fabrication, on aboutit à une règle de dessin de 1,1 micromètres. Ces techniques ne permettent pas d'envisager facilement la réalisation de mémoires non volatiles à 1 megabit de capacité.

On connaît des tentatives d'auto-alignement de la réalisation des grilles flottantes qui permettraient de s'affranchir, au moins dans certains cas, totalement de la règle de dessin. Par exemple dans "SELECTIVE POLYSILICON OXYDATION TECHNOLOGY FOR DEFECT FREE ISOLATION" du à J. MATSUNAYA, N. MATSUKAWA, H. NOZAWA et S. KOHYAMA et publié au congrés IEDM en 1980 (page 565 du résumé des conférences), ainsi que dans "SEPOX COMPATIBLE HIGH DENSITY FLOATING GATE EPROM STRUCTURE" du à N.MATSUKAWA, Y. NIITSU, J. MATSUNAGA, H. NOZAWA et S.KOHYAMA et publié dans DIGITAL TECHNIC PAPERS SYMPOSIUM VLSI TECHNOLOGY, page 108 à 109, en septembre 1983, on propose un tel procédé d'auto-alignement. Dans ce procédé proposé on réalise sur un substrat de silicium une couche d'oxyde de grille. On y dépose ensuite une couche de polysilicium. Sur cette couche de polysilicium on dépose une couche de nitrure de silicium, et on définit des ilôts de nitrure correspondant à des lieux où on veut ultérieurement réaliser les grilles flottantes. Une fois que cette définition est terminée, on fait croître un oxyde d'isolation entre les ilôts. On peut montrer qu'en agissant ainsi on obtient un auto-alignement de la largeur de la grille flottante sur des extrémités en bec d'oiseau des régions en oxyde épais destinées à séparer les points mémoires. Cependant, ce procédé proposé qui permet une augmentation de l'intégration du fait de l'auto-alignement, présente des inconvénients.

D'une part, ainsi qu'on le verra plus loin en un diagramme comparé entre ce procédé et le procédé de la présente invention, le coefficient de couplage entre la grille flottante et la grille de commande des transistors à grille flottante est réduit par rapport à celui des transistors des mémoires conventionnelles ainsi que par rapport à celui des transistors des mémoires de l'invention. D'autre part, dans une mémoire, à côté du plan mémoire il y a des circuits périphériques destinés à gérer la mémoire. Alors que les transistors à grille flottante des points mémoires sont réalisés avec deux niveaux de polysilicium, un niveau dit Poly 1 et un niveau dit Poly 2, les transistors des circuits périphériques de la mémoire ont des grilles de commande fabriquées avec la couche de Poly 2 mise en place ultérieurement dans le procédé. Cependant, l'opération d'oxydation épaisse est faite une fois pour toute, dans tout le plan mémoire ainsi que dans les régions périphériques. On pourra montrer que l'oxydation épaisse réalisée dans ces conditions a pour effet que les extrémités en bec d'oiseau des régions d'oxyde épais viennent s'accrocher sur le dessus des régions de polysilicium du premier niveau réalisé avant cette opération d'oxydation épaisse. En quelque sorte le bec d'oiseau surplombe, en biseau, les bords de la couche de Poly 1.

Lorsque, dans les régions périphériques du plan mémoire, on enlève la couche de Poly 1 par plasma, ces becs surplombant empêchent l'enlèvement de filaments de polysilicium qu'en quelque sorte ils protègent. De manière à enlever ces filaments qui pourraient ultérieurement constituer des courts-circuit, il est proposé une deuxième oxydation destinée à oxyder ces filaments,cette oxydation pouvant d'ailleurs constituer l'oxyde de grille des grilles des transistors faits avec le Poly 2. Cependant cette oxydation est en fait difficilement maîtrisée. On ne sait en particulier pas vraiment à quel moment elle est achevée de telle sorte que le compromis entre ces deux opérations d'oxydation des filaments et de constitution d'oxyde de grille est rarement trouvé. Ceci nécessite de faire ces deux opérations séparément, ce qui allonge d'autant le procédé de fabrication. En outre, le contrôle de la largeur des grilles flottantes est soumis au contrôle de l'oxydation latérale du Poly 1 sous le nitrure. Ce contrôle est totalement lié à la reproductibilité du procédé de fabrication c'est à dire notamment le contrôle de l'épaisseur de cette couche de Poly 1, la qualité du polysilicium qui la constitue et le contrôle de son dopage. Cet ensemble comporte beaucoup trop de paramètres différents pour être susceptible de rentrer dans un procédé de type industriel.

L'invention à pour objet de remédier à ces inconvénients en empêchant notamment que les couches de polysilicium Poly 1 soient enterrées sous les extrémités des becs d'oiseau de l'oxyde épais. En effet en empêchant cet enterrement, l'attaque ultérieure par plasma n'a pas à souffrir de la présence des filaments et par conséquent toutes les opérations portant sur les oxydations préalables au dépôt la couche du Poly 2 peuvent à nouveau être menées classiquement. De cette manière on bénéficie de l'avantage de l'auto-alignement pour augmenter l'intégration des points mémoire, sans avoir à réaliser d'opérations spéciales dans ce but.

A cet effet l'invention a pour objet un procédé d'auto-alignement des grilles flottantes des transistors à grille flottante d'une mémoire non volatile comportant dans l'ordre les étapes suivantes :
- on réalise sur un substrat de silicium une couche d'oxyde de grille,
- on dépose une première couche de polysilicium,
- on dépose une première couche de nitrure de silicium,
- on définit des îlots de nitrure correspondant aux lieux des grilles flottantes,
- on fait croître un oxyde d'isolement entre les îlots, caractérisé en ce que,
- avant la croissance de l'oxyde d'isolement on réalise des espaceurs de nitrure sur les bords des îlots.

L'invention a également pour objet une mémoire en circuit intégré munie de points mémoires à transistor à grille flottante, ces grilles flottantes étant auto-alignées sur des régions d'isolement en oxyde épais, caractérisée en ce que les grilles flottantes comportent des ailes qui s'appuient sur le dessus d'extrémités en bec d'oiseau des régions en oxyde épais.

L'invention sera mieux comprise à la lecture de la description qui suit et à l'examen des figures qui l'accompagnent. Celles-ci ne sont données qu'à titre indicatif et nullement limitatif de l'invention. Les figures montrent :
- figures 1 a et 1 b : une représentation comparée des étapes principales du procédé de l'état de la technique cité et de celui de l'invention;
- figure 2 : la représentation schématique d'un point mémoire comportant un transistor à grille flottante,
- figure 3 : une vue de dessus d'une partie du plan mémoire d'une mémoire réalisée selon le procédé de l'invention

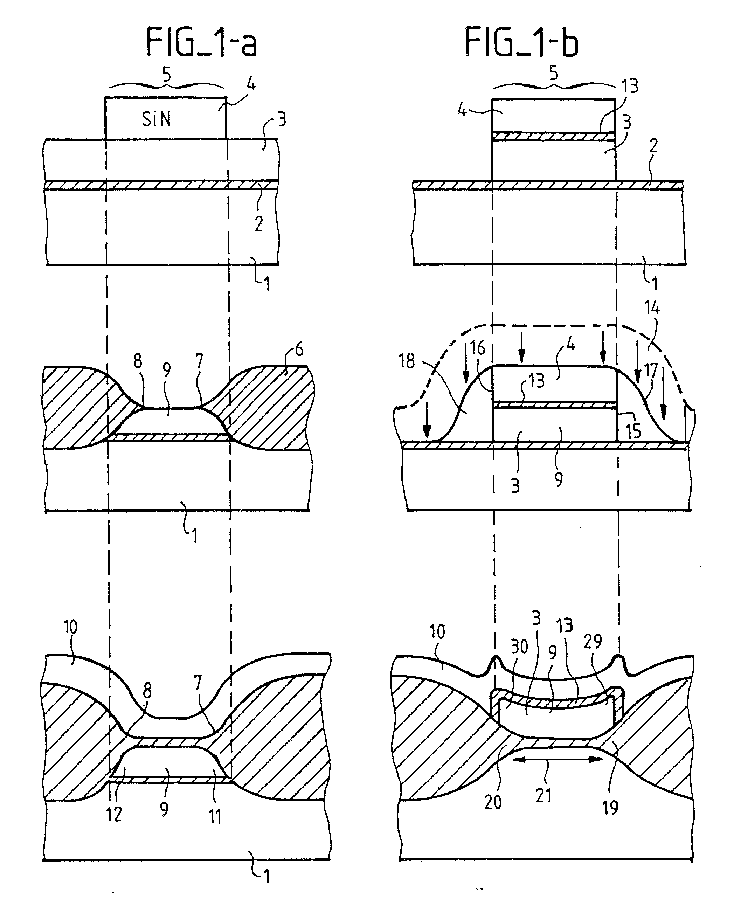

Les figures 1 a et 1 b représentent respectivement les principales étapes du procédé de l'état de la technique et de l'amélioration apportée par l'invention. Dans l'état de la technique, sur un substrat semiconducteur 1 on réalise une couche d'oxyde de grille 2. On dépose au-dessus de cette couche 2 une première couche 3 de polysilicium. Elle est destinée à servir de niveau de Poly 1. Eventuellement elle peut même être dopée. Au-dessus de cette première couche de polysilicium, on dépose une première couche 4 de nitrure de silicium. Par une première opération de photolithographie on définit des îlots 5 de nitrure correspondant aux zones d'oxyde mince : là où les grilles flottantes vont se superposer aux canaux de conduction des transistors à grille flottante des points mémoires. L'attaque chimique qui permet de définir les îlots 5 s'arrête au-dessus et au raz de la couche 3 du Poly 1.

En une deuxième étape, montrée immédiatement sous la figure du haut, on fait croître un oxyde d'isolement épais 6 dans toute les régions inactives. Il est important de remarquer que cet oxyde épais croît naturellement en bec d'oiseau sur ses bords et que les extrémités respectivement 7 et 8 de ces becs d'oiseau viennent surplomber une bande 9 de la couche 3 protégée de l'oxydation par l'épaisseur de nitrure de silicium qui la surmonte. Cette oxydation est telle que section de bande 9 du Poly 1 prend l'allure d'un trapèze avec une grande base en bas. La troisième étape importante du procédé, montrée encore immédiatement endessous, montre une couche 10 de Poly 2 en bande croisant une bande 9 de Poly 1. Dans les parties périphériques du plan mémoire la couche de Poly 1 a dû être enlevée et la couche de Poly 2 sert à réaliser les grilles des transistors de ces circuits périphériques. L'enlèvement par attaque par plasma des îlots 9 inutiles de ces parties périphériques laisse subsister des filaments 11 et 12 situés à l'aplomb et en-dessous des becs 7 et 8. Ce sont ces filaments qu'il est ultérieurement nécessaire d'enlever par oxydation pour éviter les troubles qu'ils sont susceptibles d'apporter pour le fonctionnement des circuits logiques périphériques des mémoires.

Dans l'invention le début du procédé est comparable. Sur un substrat semiconducteur 1, on réalise également un oxyde de grille 2 que l'on surmonte d'une première couche de polysilicium 3, éventuellement dopée, et destinée à servir de grille flottante des transistors à grille flottante des points mémoires. Cependant, avant de déposer la couche de nitrure de silicium 4 on procède de préférence à une fine oxydation 13 de la couche 3 de polysilicium. L'oxydation fine 13 n'est pas absolument nécessaire. Comme on le verra plus loin elle est utile pour éviter qu'au moment de la croissance de l'oxyde épais la couche 4 n'induise des efforts mécaniques destructeurs dans la couche 3 de polysilicium qu'elle surplombe. Par une opération de photolithographie comparable à celle de procédé de l'état de la technique on définit ensuite également les îlots 5 où sont censées se placer les grilles flottantes. Seulement, plutôt qu'une gravure chimique on procède alors à une gravure par plasma réactif de manière à graver également à cet endroit la couche 3 du polysilicium du premier niveau. En effet dans l'état de la technique montré à côté, l'attage chimique s'arrête au-dessus de la couche 3 de polysilicum.

Alors que la couche 4 de nitrure de silicium a une épaisseur d'environ 0,2 micromètre, on dépose, après la photolithographie et la gravure réactive, une couche 14 de nitrure de silicium d'épaisseur plus fine. Le deuxième dessin de la figure 1b montre d'une manière exagérée la couche 14 limitée par des tirets. Puis on grave plein champ, c'est à dire sur la totalité de la mémoire, par gravure plasma de manière à enlever la couche 14. On peut alors ainsi réaliser, sur les flancs 15 et 16 ilôts 5, des espaceurs respectivement 17 et 18 en nitrure de silicium. Cette opération ne nécessite aucun masquage puisque autant le dépôt de la couche 14 que sa gravure sont faits sur la totalité de la mémoire. On peut montrer que la mise en place en surépaisseur de la couche de nitrure 14 au bord des ilôts 5 laisse subsister après la gravure plein champ les espaceurs 17 et 18.Cette technique présente deux particularités. Premièrement au moment de l'oxydation épaisse, montrée par le dessin du bas de la figure 1 b, la couche de polysilicium 3, protégée sur ses bords par les espaceurs 17,18 et sur son dessus par la couche 4, sera préservée. Ses dimensions ne sont pas altérées par des phases ultérieures du procédé de fabrication dont éventuellement on maitriserait mal l'efficacité,

Et deuxièmement les extrémités en becs d'oiseau 19 et 20 qui se produisent en bordure de l'oxyde épais viennent maintenant se placer en-dessous des bandes 9 de polysilicium de premier niveau. Ce faisant elles les soulèvent légèrement sur le rebord. Ceci justifie la présence de la couche 13 d'oxyde entre le nitrure 4 et le polysilicium de la couche 3. Sans cet oxyde 13 le nitrure 4 effriterait le polysilicium 3. Lorsque l'opération d'oxydation épaisse est terminée, on enlève tout le nitrure de silicium et on réalise comme précédemment la couche de polysilicium 10 du deuxième niveau. On remarque en outre que pour l'attaque par plasma, dans les régions périphériques du plan mémoire, de la couche de silicium du premier niveau aucune partie de cette couche ne reste enterrée sous les becs 19 et 20 de l'oxyde épais.

Par ailleurs, en comparant les sections de couplage électrostatique entre les bandes 9 du polysilicium du premier niveau et les couches 10 du polysilicium du deuxième niveau on constate que la surface du couplage peut être plus grande, dans l'invention, que la largeur utile 21 du canal de conduction des transistors. Par contre, la forme en trapèze à grande base en bas de l'état de la technique nécessite, pour augmenter la surface de couplage, d'augmenter en même temps la largeur de conduction ce qui modifie les conditions de fonctionnement du point mémoire. On remarquera surtout que, puisque le polysilicium de la couche 3 n'est pas attaqué, il n'est pas nécessaire d'en maîtriser, de ce point de vue, rigoureusement la qualité ni le dopage qu'il peut subir. En agissant ainsi on confère donc au procédé de fabrication plus de souplesse.

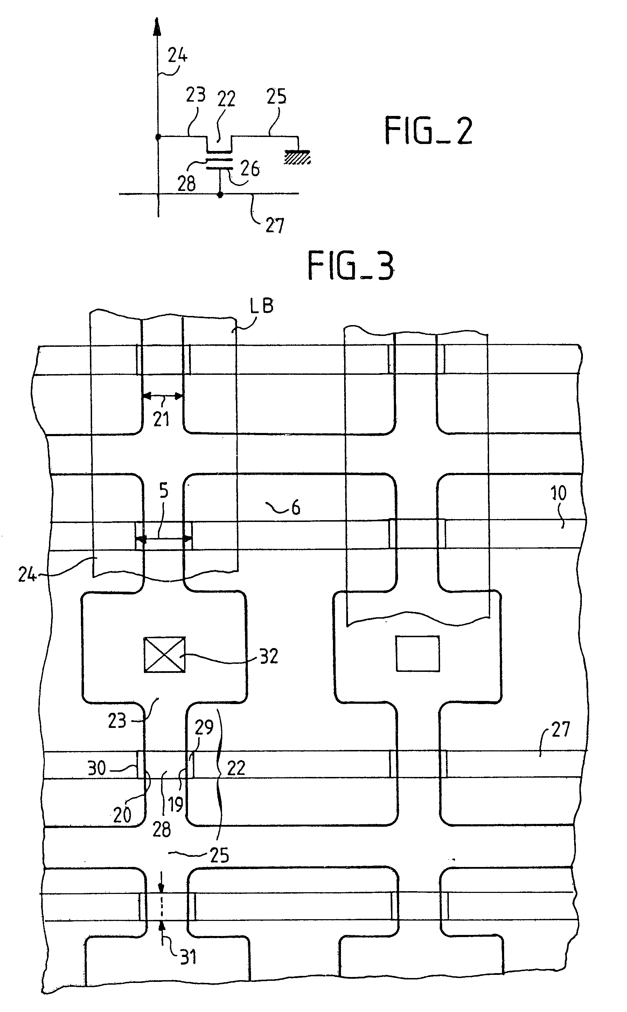

La figure 2 montre d'une manière schématique un point mémoire muni d'un transistor 22 à grille flottante. Ce transistor 22 comporte un drain 23 relié à une ligne de bits 24, une source 25 reliée à la masse, et une grille de commande 26 reliée à une ligne de mot 27. La grille flottante 28 est placée à l'aplomb de la grille de commande 26. La figure 3 reprend les mêmes éléments que les figures 2 et 1a précédentes. Elle est une vue de dessus. On constate que la grille flottante 28 déborde légèrement par les ailes 29 et 30 sur les becs 19 et 20 de l'oxyde épais 6. Ceci est également visible sur la figure 1b. Les ailes 29 et 30 sont bien entendu de dimension plus faible que la règle de dessin qu'on aurait dû utiliser si on n'avait pas effectué d'auto-alignement. eEn définitive la mise en oeuvre du procédé de l'invention est particulièrement décelable par la finesse des ailes 29 et 30,et par leur parfait alignement symétrique sur les becs 19 et 20 des oxydes épais.En effet comme l'oxydation épaisse occupe les espaces entre les ilôts elle se répartit également de chaque côté de ces ilôts. Dans la pratique la grille de commande et la ligne de mot 27 sont confondues en une deuxième couche 10 de polysilicium du deuxième niveau. Au moment de la définition des lignes de mot 27, on en profite pour définir en même temps la longueur 31 des canaux de conduction des transistors. D'une manière classique les lignes de bits 24 sont métallisées, en aluminium, et viennent se connecter au drain 23 des transistors des points mémoire par des prises de contact 32.

**Revendications**

1 - Procédé d'auto-alignement des grilles flottantes (9) des transistors à grille flottante d'une mémoire non volatile comportant dans l'ordre les étapes suivants :
- on réalise sur un substrat (1) de silicium une couche (2) d'oxyde de grille,
- on dépose une première couche (3) de polysilicium,
- on dépose une première couche (4) de nitrure de silicium,
- on définit des ilôts (5) de nitrure correspondant aux lieux des grilles flottantes,
- on fait croître (6) un oxyde d'isolement entre les ilôts, caractérisé en ce que
- avant la croissance de l'oxyde d'isolement on réalise des espaceurs (17 et 18) de nitrure sur les bords des ilôts.

2 - Procédé selon la revendication 1 caractérisé en ce qu'on réalise les espaceurs par dépôt d'une deuxième couche (14) fine de nitrure de silicium et par une gravure plasma plein champ de cette deuxième couche de nitrure.

3 - Procédé selon l'une quelconque revendications 1 et 2 caractérisé en ce qu'on dope la première couche de polysilicium avant de déposer la première couche de nitrure de silicium.

4 - Procédé selon l'une quelconque des revendications 1 à 3 caractérisé en ce qu'on oxyde (13) légèrement la première couche de polysilicium avant le dépôt de la deuxième couche de nitrure.

5 - Procédé selon l'un quelconque des revendications 1 à 4 caractérisé en ce qu'on définit les îlots par gravure plasma réactive.

6 - Procédé selon l'une quelconque des revendications 1 à 5 caractérisé en ce qu'on définit la longueur de conduction des canaux de conduction des transistors à grille flottante en définissant des lignes de mot (27) de la mémoire.

7 - Mémoire en circuit intégré munie de points mémoires à transistor à grille flottante, ces grilles flottantes étant auto-alignées sur des régions d'isolement en oxyde épais, caractérisée en ce que les grilles flottantes comportent des ailes (29 et 30) qui s'appuient sur le dessus d'extrémités (19 et 20) en bec d'oiseau des régions en oxyde épais.

## FIG_1-a

5
4
SiN
3
2
1

8 9 7 6
1

10
8 7
12 9 11
1

## FIG_1-b

5
13
4
3
2
1

14
18 16 4 17
13
15
3 9

10 3 13 29
30 9
20 21 19

# FIG_2

# FIG_3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | US-A-4 426 764  (KOSA et al.)<br>* Colonne 5, ligne 13 - colonne 6, ligne 24; colonne 7, lignes 9-19; figures 5-16 * | 1,2,4,5 | H 01 L  21/28<br>H 01 L  21/82<br>H 01 L  21/76<br>H 01 L  29/78 |
| X | | 7 | |
| | --- | | |
| Y | IBM TECHNICAL DISCLOSURE BULLETIN, vol. 24, no. 10, mars 1982, pages 5115-5118, New York, US; I.E. MAGDO et al.: "Self-aligned ROI to SAM structure"<br>* En entier * | 1,2,4,5 | |
| | --- | | |
| Y | IBM TECHNICAL DISCLOSURE BULLETIN, vol. 26, no. 3B, août 1983, pages 1318-1322, New York, US; N. LU: "High-capacitance dynamic RAM cell using buried polysilicon electrodes and buried oxide MOS transistors"<br>* Page 1321, ligne 8 - page 1322; figures * | 1,2,4,5 | |
| | --- | | **DOMAINES TECHNIQUES RECHERCHES (Int. Cl.4)** |
| A | IEEE INTERNATIONAL ELECTRON DEVICES MEETING, Technical Digest, Washington DC, US, 4-6 décembre 1978, pages 181-184, IEEE, New York, US; M. KIKUCHI et al.: "A new technique to minimize the EPROM cell"<br>* Page 181, "Fabrication process"; page 183, figure 2; tableau 1 * | 1,3,4,6 | H 01 L |
| | --- | | |
| A | US-A-4 151 021  (Mc ELROY)<br>* Colonne 4, ligne 2 - colonne 5, ligne 33 * | 1-7 | |
| | --- | | |
| A | GB-A-2 092 824  (KABUSHIKI K.K.)<br>* Figure 1; revendications * | 1-7 | |
| | ----- | | |

Le présent rapport a été établi pour toutes les revendications

| Lieu de la recherche | Date d'achèvement de la recherche | Examinateur |
|---|---|---|
| LA HAYE | 13-12-1988 | GELEBART Y.C.M. |